# EUROPEAN PATENT APPLICATION

(11) **EP 3 181 966 A1**
(43) Date of publication of application: **21.06.2017**
(21) Application number: 15201352.0
(22) Date of filing: 18.12.2015
(51) Int. Cl.: F16K 31/02, H05K 7/14

(54) **AN ELECTRIC ACTUATOR**

(71) Applicant: IMI Hydronic Engineering International SA, 1262 Eysins (CH)
(72) Inventor: VOLOVEC, Peter, 8258 KAPELE (SI); CARETTE, Jean-Christophe, 1066 EPALINGES (CH); BOZIC, Gregor, 8270 KRSKO (SI)
(74) Representative: Awapatent AB

(57) **Abstract**

The present inventive concept relates to an electric actuator for controlling a motor operated valve. The electric actuator comprises a housing, a main circuit board arranged inside the housing, the main circuit board being configured to transmit a motor control signal for controlling the motor operated valve. The electric actuator further comprises a board rack arranged inside the housing, the board rack being configured to receive a plurality of circuit boards, wherein the board rack comprises a plurality of guiding structures, each guiding structure enabling one of the plurality of circuit boards to be guided into and/or removed from the board rack. The present inventive concept also relates to a method for inserting and/or removing a circuit board in an electric actuator.

## Description

### Technical field of the Invention

The present inventive concept relates to an electric actuator for controlling a motor operated valve. The present inventive concept also relates to a method for inserting and/or removing a circuit board in such electric actuator, and to an actuator-valve assembly.

### Background of the Invention

Fluid distribution systems, for e.g. heating, cooling and water supply are designed to feed a fluid from a source to a consumption point. Each consumption point typically has a calculated and designed flow or differential pressure requirement. However, depending on the type of hydronic system, the flow requirement is often variable over time and can change with factors like seasonality (e.g. summer or winter), that changes the load from the consumption points, temperature changes of the system fluid, changes in consumption of the system fluid (e.g. for drinking water).

Control valves are frequently used in fluid distribution systems and have a variable opening such that the flow rates can be controlled. An actuator for controlling the position of such a valve is often provided. Such an actuator is normally driven by means of a motor which drives an actuator spindle. The actuator spindle is in turn connected to a valve rod for controlling the opening degree of the valve.

In some instances, the conditions of the fluid distribution system will change and the control valve might have to be replaced in order to correspond to the new conditions. For such cases, the actuator might have to be replaced with a new actuator which is configured to control the new control valve. In other instances, the control valve is not changed but the requirements of controlling the control valve are changed, or the desired manner to which the control valve is controlled is changed. For such cases, the actuator might have to be replaced in order to correspond to the new requirements, or to the new desired control manner of the control valve.

However, replacing the actuator give rise to additional work and additional costs. Thus, there is a need in the industry for an improved actuator.

### Summary of the Invention

It is an object of the present inventive concept to improve the current state of the art, to at least partly solve the above problem and to provide an improved actuator. These and other objects are achieved by an electric actuator, to a method for alternating circuit boards in such electric actuator and by an actuator-valve assembly.

According to a first aspect of the present inventive concept an electric actuator for controlling a motor operated valve is provided. The electric actuator comprises:
a housing,
a main circuit board arranged inside said housing, said main circuit board being configured to transmit a motor control signal for controlling the motor operated valve,
a board rack arranged inside said housing, said board rack being configured to receive a plurality of circuit boards,
wherein said board rack comprises a plurality of guiding structures, each guiding structure enabling one of the plurality of circuit boards to be guided into and/or removed from said board rack.

By providing guiding structures enabling at least one of the plurality of circuit boards which the board rack is configured to receive, to be guided into and/or removed from said board rack, function or functions corresponding to the inserted and/or removed circuit board(s), may be included to and/or removed from the electric actuator upon choice. Thus, instead of replacing the existing actuator in a fluid distribution system when e.g. the conditions in the fluid distribution system changes, and the actuator controlled control valve (i.e. the motor operated valve) is to be replaced, and/or when the desired manner to which the control valve is controlled by the actuator is changed, the function or functions of the electric actuator can be adapted to the new conditions and/or the new requirements by providing means for (i.e. the guiding structure) easily altering the number of circuit boards connected to the actuator.

In other words, each one of the plurality of circuit boards which the board rack is configured to receive, can, once they have been inserted into the board rack and thereby been connected to the electric actuator, be described as detachably arranged to said board rack. Described differently, the board rack and its guiding structure provide means for allowing a plurality of circuit boards to be detachably connected to said board rack.

When one of the plurality of circuit boards has been inserted into the board rack (i.e. when the circuit board has been attached to the board rack and thereby be connected to the actuator), the guiding structure may, according to at least one example embodiment, support the respective circuit board in its position in the board rack.

According to at least one example embodiment, each one of said guiding structures comprises a set of guiding rails for slidably arranging one of the plurality of circuit boards in said board rack.

The board rack may according to at least one example embodiment be referred to as a circuit board rack, or a rack for circuit boards.

Hereby, one of the plurality of circuit boards may easily be guided and inserted into the board rack by sliding the circuit board along the guiding rails. Furthermore, one of the plurality of circuit boards may easily be guided and removed from the board rack by sliding the circuit board along the guiding rails.

For example, the size or the length of at least one set guiding rails may be of substantially the same size or the same length as the circuit board inserted (or intended to be inserted) into the board rack via the corresponding set of guiding rails. In other words, the size or the length of one of the circuit boards in the plurality of circuit boards, or the size and the length of the main circuit board, inserted into said board rack by the corresponding set of guiding rails is substantially of the same size or the same length as of the corresponding set of guiding rails. Here, the size or the length is to be interpreted as the length of the main extension of a guiding rail in a set of guiding rails, and the length of the main extension of the respective circuit board, respectively.

The sliding rails may also support the respective circuit board in the board rack, once the circuit board has been inserted into the board rack.

According to at least one example embodiment, each one of said guiding structures comprises a guiding receiving element for slidably receiving one of the plurality of circuit boards in said board rack.

For example, the size or the length of said guiding receiving element may be smaller, or substantially smaller, than the size or length of the circuit board received by (or intended to be received by) the board rack via the receiving element. For example, the guiding receiving means may have a size or length of 10 % - 50 % of the size or length of the respective circuit board. Here, the size or the length is to be interpreted as the length of the main extension of the guiding receiving element, and the length of the main extension of the respective circuit board, respectively.

According to at least one example embodiment, the electric actuator further comprises at least one secondary circuit board configured to transmit a signal to and/or receive a signal from said main circuit board.

In other words, said at least one secondary circuit board is a circuit board in the plurality of circuit boards which said board rack is configured to receive. Said at least one secondary circuit board is arranged in the board rack in operational connection with the main circuit board. Operational connection is to be understood as that the circuit boards are connected to each other such that they may communicate with each other by means of signal transferring.

It should be understood that said at least one secondary circuit board may be attached to the board rack and thereby be connected to, and included in, the electric actuator prior to transporting and/or installing the electric actuator to a motor operated valve. In other words the at least one secondary circuit board may be a prior installed secondary circuit board, where "prior installed" is indicating prior relative to transporting and/or installing the electric actuator to the motor operated valve, explained in more detail further below. Furthermore, the at least one secondary circuit board may subsequently be detached from the board rack and thereby disconnected from the electric actuator. Thus, depending on the function or functions corresponding to said at least one secondary circuit board, this function or these functions may be included in, replaced in and/or removed from the electric actuator depending on whether said at least one secondary board is connected to, or is disconnected from, the electric actuator.

For example, if the electric actuator does not include a function related to wireless communication, a secondary circuit board comprising features enabling wireless communication may be connected to the electric actuator by being guided into the guiding structure of the board rack and thereby become attached (i.e. detachably arranged) to the board rack. Preferably, the main circuit board is prepared to communicate with the secondary circuit board(s) attached to the board rack (i.e. here, the main circuit board is prepared to communicate with a circuit board having features providing wireless communication).

According to at least one example embodiment, said at least one secondary circuit board is detachably arranged to said board rack. In other words, the at least one secondary circuit board may be referred to at least one detachably arranged secondary circuit board.

According to at least one example embodiment, the at least one secondary circuit board is one of the following: a communication board, a high voltage board, a relay board, a digital output port, a radio board, a measuring/logging board.

However, it should be noted that the at least one secondary circuit board may comprise, or be configured to carry out, more than one function. Thus, the at least one secondary circuit board may be a circuit board which is configured to carry out the functions of at least two of the above mentioned examples of circuit boards. For example, the relay board may provide relays but also comprise means for providing a binary input and means for providing an output signal (e.g. a current signal in e.g. milli-amperes), while the main circuit board may provide means for a different output signal (e.g. in a voltage signal). Thus, instead of configuring the electric actuator to operate by means of e.g. setting values of between 0 - 10 volts, the electric actuator can be configured to operate by means of setting values of e.g. 0 - 40 milli-amperes.

The circuit boards may be described as in the following paragraph: a communication board e.g. for providing BUS communication means (here the BUS communication means may provide a typical BUS communication protocol as used in the building industry such as e.g. what is commonly abbreviated as KNX, BACnet, ModBus, and/or LonWorks); a high voltage board e.g. for transforming the current from a high voltage source to the desired voltage of the main circuit board; a relay board e.g. for providing switching means or switching capabilities to the electric actuator, whereby switching means here should be understood as means providing the ability to switch a device on and off, e.g. one or more external devices electrically connected to the electric actuator (e.g. by an electro-mechanical change-over relay that are mounted on e.g. the relay board and that can be switched or toggled from an activated state to a deactivated state in order to open or close a circuit connected to the respective external device, in order to make the respective external device to react to the switching or toggling), the relay board may e.g. comprise relays connected to e.g. a pump, a heater, and/or a controller (e.g. to switch from one sensor to another sensor); a digital output board e.g. for transforming an analog signal to a digital signal (according to one example this function is included in the (BUS) communication boards) or for communicating digitally between different circuit boards; a radio board e.g. for transmitting and/or receiving a wireless signal; a measuring/logging board e.g. for receiving, treating and/or logging a signal from a sensor such as e.g. from a pressure, differential pressure or temperature sensor. The measuring/logging board may of course be configured to receive a plurality of signals from a plurality of sensors.

According to at least one example embodiment, the electric actuator comprises at least two secondary circuit boards, wherein any one, or both, of the two secondary circuit boards are chosen from the following circuit board types: communication board, high voltage board, relay board, digital output board, a radio board, measuring/logging board.

In other words, said electric actuator may comprise at least a first prior installed secondary circuit board, and a second prior installed secondary circuit board.

Thus, according to at least one example embodiment, the plurality of circuit boards which the board rack is configured to receive, may refer to a plurality of secondary circuit boards connected to the actuator prior to transporting and installing the electric actuator to a motor operated valve, i.e. so called prior installed secondary circuit boards, such as e.g. said at least two secondary circuit boards being e.g. a first secondary circuit board (e.g. a communication board), and a second secondary circuit board (e.g. a radio board).

According to at least one example embodiment, the electric actuator comprises at least two circuit boards of the plurality of circuit boards which the board rack is configured to receive. That is, according to at least one example embodiment, said electric actuator comprises at least one prior installed secondary circuit board.

However, it should be noted that the electric actuator does not need to include any secondary circuit boards when first being transported and installed to a motor operated valve in e.g. a fluid distribution system. Thus, any number of secondary circuit boards may be connected to the electric actuator after it has been transported and/or installed to the motor operated valve, for example when retrofitting the electric actuator and/or modifying the electric actuator. These secondary circuit boards may be referred to as later installed secondary circuit boards which is explained in more detail further below.

Thus, according to at least one example embodiment, said electric actuator does not comprise any secondary circuit boards. That is, the electric actuator is only prepared for receiving secondary circuit boards (i.e. in the board rack by the guiding structure), such as later installed secondary circuit boards.

According to at least one example embodiment, said main circuit board is arranged in said board rack.

In other words, the main circuit board may be a circuit board in the plurality of circuit boards which the board rack is configured to receive.

Thus, according to at least one example embodiment, the plurality of circuit boards which the board rack is configured to receive may refer to the main circuit board and any number of later installed secondary circuit boards and/or any number of prior installed secondary circuit boards.

According to at least one example embodiment, said main circuit board is arranged in said electric actuator outside of said board rack (for example in a main circuit board support structure).

To summarize, the plurality of circuit boards which the board rack is configured to receive, may refer to
any number of later installed secondary circuit boards which are to be connected to the electric actuator after the electric actuator has been transported and/or installed to a motor operated valve (i.e. these secondary circuit boards are not included in the electric actuator from the beginning, e.g. not included when leaving the manufacturing facility of the electric actuators, but the board rack is on the other hand configured to receive these secondary circuit boards later upon choice from the user/operator), or

it may refer to the main circuit board and any number of secondary circuit boards, e.g. such later installed secondary circuit boards described in the previous paragraph, and/or the any number of prior installed secondary circuit boards, such as e.g. the above referred to said at least one secondary circuit board or said at least two secondary circuit boards, arranged in the board rack and included in the electric actuator prior to transporting and/or installing the electric actuator to a motor operated valve (e.g. such secondary circuit board(s) installed at the manufacturing facility of the electric actuators), or
it may refer to (e.g. in embodiments where the main circuit board is not arranged in the board rack) any combination of later installed secondary circuit boards and prior installed secondary circuit boards.

Thus, a secondary circuit board may either be a later installed secondary circuit board or it may be a prior installed secondary circuit board. Reference to only a "circuit board" may be either to the main circuit board or any one of the secondary circuit boards. The term "the circuit boards" (i.e. in plurals) is typically referring to the main circuit board and any number of secondary circuit boards.

According to at least one example embodiment, said main circuit board is detachably arranged to said board rack. In other words, the main circuit board may be referred to at least one detachably arranged main circuit board.

It should be noted that the main circuit board is different from any one of the secondary circuit boards (such as e.g. said at least one secondary circuit board), in that the main circuit board is configured to at least transmit a motor control signal to the motor operated valve, and transmit a signal to, and/or receive a signal from any one of the secondary circuit boards. In other words, the main circuit board is configured to control an electric motor (e.g. an electric motor in the actuator or an electric motor integrated into the valve).

The main circuit board may e.g. include other functions such as e.g. stroke detection of the valve rod connected to the electric actuator and/or stroke detection of the actuator spindle. It should be understood that the main circuit board can drive the electric motor to move the valve rod to a (new) position corresponding to the received input signal supplied to the main circuit board.

According to at least one example embodiment, the electric actuator further comprises a back plate comprising a connector connecting said back plate to said main circuit board.

Hereby, the main circuit board may be connected and supported by the back plate.

According to at least one example embodiment, said back plate comprises a plurality of connectors for connecting said back plate to said main circuit board, and for connecting said back plate to at least one of the plurality of circuit boards which the board rack is configured to receive, such as a secondary circuit board. For example, the back plate comprises connectors connecting said back plate to the main circuit board and at least one (or two or any higher number of) secondary circuit board(s) connected to the electric actuator. Preferably, the back plate is in common for all of the circuit boards (i.e. the main circuit board and any of the secondary circuit boards) connected to the electric actuator.

According to at least one example embodiment, said back plate is back circuit board (i.e. a circuit board arranged as a back plate).

According to at least one example embodiment, said back plate comprises a communication circuitry enabling signal transfer between the main circuit board and at least one of the plurality of circuit boards.

Here, "at least one of the plurality of circuit boards" refers to any number of secondary circuit boards (either after installed secondary circuit boards or prior installed secondary circuit boards).

Hereby, the circuit boards attached to the board rack (and thereby connected to the electric actuator) may transfer signals (e.g. communicate) between each other via the back plate. For example, the back plate comprises a communication circuitry enabling power and signal transfer between the main circuit board and at least one secondary circuit board (or the at least two or a higher number of secondary circuit boards). Thus, the secondary circuit board may transmit and/or receive a signal to and/or from the main circuit board via the back plate. Additionally, the communication circuitry may enable signal transfer between any two secondary circuit boards. Thus, according to this example, two of the secondary circuit boards may transmit and/or receive a signal to and/or from each other. It should be noted that the signal transfer between two circuit boards attached to the board rack is referring to transmitting and/or receiving a signal between the two circuit boards.

According to at least one example embodiment, the main circuit board may power at least one secondary circuit board via said back plate, such as e.g. via the communication circuitry of the back plate.

According to at least one example embodiment, said back plate is perpendicularly arranged compared to the main circuit board.

Hereby, the back plate is arranged in a suitable configuration for connection to at least the main circuit board.

According to at least one example embodiment, said back plate is perpendicularly arranged compared to any one of the plurality of circuit boards which the board rack is configured to receive, and/or any one of the secondary circuit board(s) attached to the board rack. According to at least one example embodiment, the board rack and the back plate are configured such that any circuit boards attached to the board rack become perpendicularly arranged to the back plate. For example, the guiding structure or the set of guiding rails may have their respective main extension being perpendicularly arranged compared to said back plate.

According to at least one alternative example embodiment, the back plate is angled compared to said main circuit board and/or at least one secondary circuit board.

According to at least one example embodiment, the electric actuator further comprises a set of separate wires for internally connecting the main circuit board to at least one of the plurality of circuit boards.

For example, the set of separate wires internally connects the main circuit board to at least one secondary circuit board (or any number of secondary circuit boards) and/or connects any two secondary circuit boards to each other. For example, the set of separate wires may internally connect the main circuit board to the at least one secondary circuit board.

Thus, instead of a back plate, the set of separate wires can be used to connect circuit boards to each other.

According to at least one example embodiment, said board rack comprises a plurality circuit board slots, each one of the plurality of circuit board slots being associated with (i.e. configured to receive) one of the plurality of circuit boards, and each one of the plurality of circuit board slots comprising at least one securing element for securing the respective circuit board of the plurality of circuit boards to the board rack.

For example, the main circuit board may be arranged in a first circuit board slot, a first secondary circuit board may be arranged in a second circuit board slot, and a second secondary circuit board may be arranged in a third circuit board slot, etc.

According to at least one example embodiment, said securing element is a screw, a bolt, a rivet or the like.

According to at least one example embodiment, said securing element is a snap-lock arrangement.

According to at least one example embodiment, said securing element comprises a pivoting element flexibly arranged to said board rack, which pivoting element is configured to, in a first state, flexibly pivot away from the circuit board slot to allow for a circuit board to be inserted into the circuit board slot, and in a second state, flexibly pivot back to its original position and thereby securing the circuit board in the circuit board slot.

By describing the guiding rails in relation to the circuit board slots, it should be understood that each of the circuit board slots comprises a set of guiding rails, such as e.g. a pair of guiding rails, for guiding a respective circuit board into its respective circuit board slot and supporting the respective circuit board in the board rack. For example, the circuit board slot (such as a first circuit board slot) for said main circuit board comprises a first set of guiding rails (such as a first pair of guiding rails) for guiding and supporting the main circuit board in the board rack, and the circuit board slot (such as a second circuit board slot) for a first secondary circuit board comprises a second set of guiding rails (such as a second pair of guiding rails) for guiding and supporting the first secondary circuit board in the board rack.

According to at least one example embodiment, at least two of the securing elements are arranged in a stepped manner. The two securing elements arranged in a stepped manner are associated / related to different circuit board slots.

Hereby, attaching a circuit board to and/or detaching a circuit board from the board rack is facilitated.

Thus, according to such embodiments, at least two of the circuit boards attached to the board rack will be arranged in a stepped manner.

Hereby, the securing element may easily be accessed as the circuit boards secured by a first securing element in a higher step, does not hinder access to a securing element of another circuit board in a lower step.

When referring to the circuit boards slot and according to at least one example embodiment, at least two of the circuit board slots are arranged in the board rack in a stepped manner.

According to at least one example embodiment, said board rack comprises a plurality of circuit board levels and said board rack is configured to enable the circuit boards attached to the board rack to be arranged in a stepped manner for at least two circuit board levels. Hence, the at least two securing elements arranged in a stepped manner are arranged in at least two different circuit board levels.

In relation to the circuit board slots, and according to at least one example embodiment, at least two of the circuit board slots are arranged at different circuit board levels. According to at least one example embodiment, each one of the circuit board slots is arranged at a different circuit board level compared to the other circuit board slots. For example, the circuit board slot (such as the first circuit board slot) for said main circuit board may be arranged at a first circuit board level (the first circuit board level being e.g. the lowest circuit board level in the board rack), and the circuit board slot (such as the second circuit board slot) for a first secondary circuit board may be arranged at a second circuit board level being arranged at a different circuit board level. In the present context, the lowest level is a bottom spatial position along a vertical axis, and any higher lever is arranged on top, or over, this lowest level.

For embodiments where at least one secondary circuit board is attached to the board rack prior to installing the electric actuator to a motor operated valve (i.e. at where the actuator comprises at least one prior installed secondary circuit board), such as e.g. a first secondary circuit board, the main circuit board may be arranged in a first circuit board level (e.g. in a first circuit board slot by a first securing element), and the first secondary circuit board may be arranged in a second circuit board level (e.g. in a second circuit board slot by a second securing element). Here, the second circuit board level may be arranged on a higher level compared to the first circuit board level, and as the first and the second securing elements are arranged in a stepped manner, the first secondary circuit board does not block or hinder access to the first securing element holding said main circuit board, even though the first secondary circuit board is arranged over (i.e. on a higher level) compared to the main circuit board.

According to at least one example embodiment, said board rack is arranged in a stepped manner.

In other words, the board rack comprises a profile which is arranged in a stepped manner, i.e. comprising at least one step. Stepped in this context, is to be understood as that the board rack has a side-profile of a staircase or stairs.

According to at least one example embodiment, said housing comprises an actuator hatch being arrangeable in at least a closed position and an open position, and wherein said actuator hatch in said open position enables access to the board rack.

Hereby, easy access of the board rack from outside of the electric actuator is provided. Thus, circuit boards attached to the board rack and/or circuit boards which are to be attached to the board rack are easily removed from the board rack or inserted into the boards rack, respectively.

The actuator hatch may e.g. comprise an inner surface which is arranged to at least partly face the board rack.

According to at least one example embodiment, the electric actuator comprises:
an actuator spindle arranged at least partly inside said housing, said actuator spindle being configured to control the movement of a valve rod in order to vary an opening of the valve;
a gear arrangement;
an electric motor operatively connected to the actuator spindle via said gear arrangement.

According to at least one example embodiment, the electric motor is integrally arranged with the motor operated valve. Fur such embodiments, the electric motor is typically directly coupled to a valve rod of the motor operated valve (or alternatively is coupled to the valve rod via a gear arrangement).

According to at least one example embodiment, the electric actuator may function as described in the following paragraph. The main circuit board receives a first signal (the first signal may e.g. be a signal from a temperature sensor or a pressure sensor received by a measuring/logging board in the electric actuator), or alternatively the main circuit board includes a processing unit and/or an internally memory comprising information of how the electric actuator are to control the motor operated valve for example in an automatic calibration mode or an auto-recognition of end positions of the actuator spindle and/or the valve rod (thus, the main circuit board may comprise means for determining the current position of the actuator spindle and/or the valve rod). The electric actuator may comprise a processing unit and/or an internally memory regardless of being able to drive the electric actuator in an automatic calibration mode or an auto-recognition of end positions of the actuator spindle and/or the valve rod. The first signal may also be a digital message/signal from a BUS communication line connected to the main circuit board or to a secondary circuit board. In case the digital message/signal is communicated to the secondary circuit board, the secondary circuit board may subsequently convert the digital message/signal into a signal interpretable by the main circuit board. Subsequently the main circuit board may process the first signal (possibly by communication with a secondary circuit board attached to the board rack) and transmit a control signal to the electric motor of the electric actuator. The electric motor is operatively connected to the actuator spindle via a gear arrangement comprising at least one gearwheel. Thus, the control signal is used to initiate a rotational movement of the electric motor, which in turn transfer its rotational movement to the gear arrangement (such as to the at least one gear wheel), which gear arrangement transfer the rotational movement into a movement (reciprocal or rotational) of the actuator spindle. The actuator spindle is typically connected to a valve rod of the control valve (i.e. the motor operated valve), and the movement of the actuator spindle is thus transferred to the valve rod in order to vary the opening of the control valve.

According to at least a second aspect of the present inventive concept, a method for inserting and/or removing a circuit board in an electric actuator according to the first aspect of the present inventive concept is provided. Said method comprising the steps of:
inserting at least one secondary circuit board into the board rack, and/or
removing the main circuit board and/or at least one secondary circuit board from the board rack.

Effects and features of this second aspect of the present inventive concept are largely analogous to those described above in connection with the first aspect of the inventive concept. Embodiments mentioned in relation to the first aspect of the present inventive concept are largely compatible with the second aspect of the inventive concept.

In other words, when inserting and attaching at least one secondary circuit board into the board rack, the secondary circuit board will guided by a respective guiding structure facilitating guidance of the secondary circuit board into the board rack. Correspondingly, when removing at least one secondary circuit board from the board rack, the secondary circuit board will guided by a respective guiding structure facilitating guidance of the secondary circuit board out of the board rack.

Naturally, because the electric actuator typically needs a main circuit board to operate, if the main circuit board is removed from the electric actuator, it is followed by a step of inserting a new main circuit board into the board rack to replace the removed main circuit board.

According to at least one example embodiment, the method comprises the step of opening the actuator hatch in order to enable access to the circuit boards in the board rack prior to the step of removing and/or inserting a main circuit board and/or at least one secondary circuit board.

According to at least a third aspect of the present inventive concept, an actuator-valve assembly is provided. The actuator-valve assembly comprises an electric actuator according to the first aspect of the present inventive concept, and a motor operated valve.

According to at least one example embodiment, the motor operated valve comprises a valve integrated motor which is configured to receive a motor control signal from the main circuit board of the electric actuator.

The motor operated valve may preferably be a control valve.

Generally, all terms used in the claims are to be interpreted according to their ordinary meaning in the technical field, unless explicitly defined otherwise herein. All references to "a/an/the [element, device, component, means, step, etc.]" are to be interpreted openly as referring to at least one instance of said element, device, component, means, step, etc., unless explicitly stated otherwise.

### Brief description of the drawings

The above objects, as well as additional objects, features and advantages of the present inventive concept, will be more fully appreciated by reference to the following illustrative and non-limiting detailed description of preferred embodiments of the present inventive concept, when taken in conjunction with the accompanying drawings, wherein:
Fig. 1 is a perspective break-away view of parts of an electric actuator according to at least one example embodiment of the inventive concept;
Fig. 2 is illustrating how a circuit board can be removed and/or inserted from/to an electric actuator according to at least one example embodiment of the inventive concept;
Fig. 3 is a detailed perspective view illustrating the board rack and thereto connected circuit boards in accordance with at least one example embodiment of the inventive concept;
Fig. 4 is a schematic view of at least a part of a fluid distribution system comprising a motor operated valve and an electric actuator in accordance with at least one example embodiment of the inventive concept.

### Detailed description of the drawings

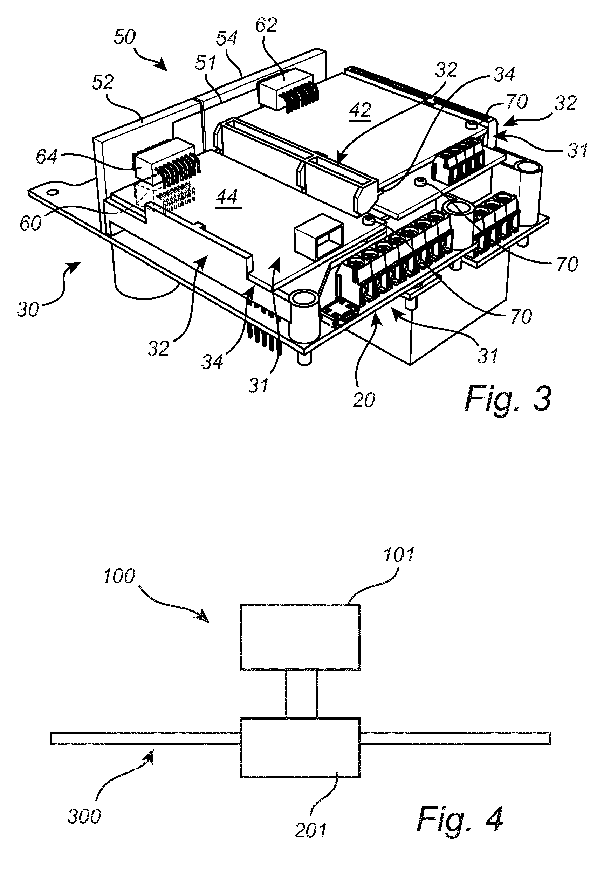

Fig. 1 shows an electric actuator 1 for controlling a motor operated valve (shown in Fig. 4). The electric actuator 1 comprises a housing 10 and a valve connecting portion 12, in Fig. 1 illustrated as connecting legs.

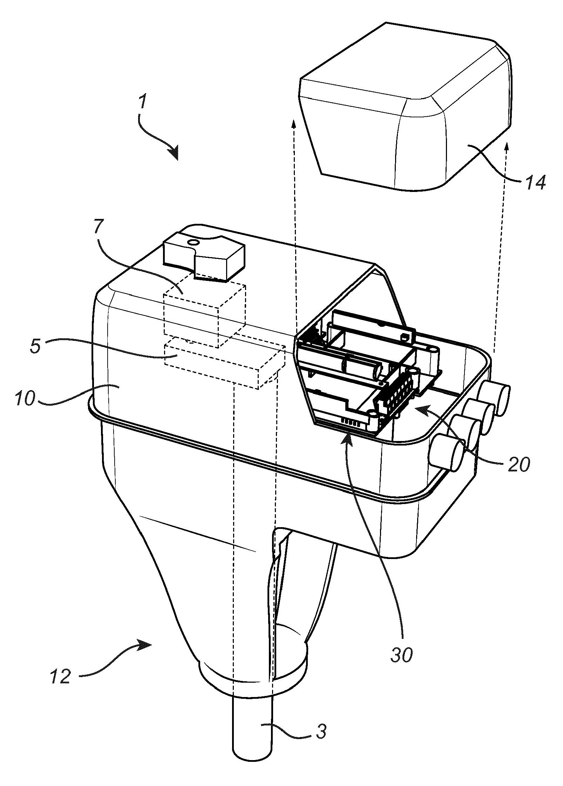

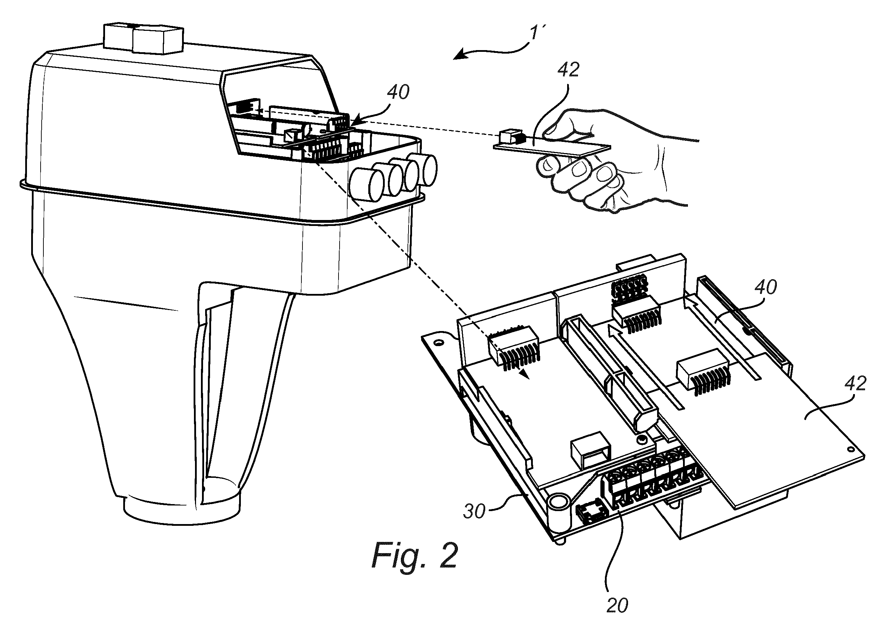

The electric actuator further comprises a board rack 30 arranged inside the housing 10, the board rack 30 being configured to receive a plurality of circuit boards (shown in Fig. 2). In Fig. 1, at least a main circuit board 20 is arranged in the board rack 30. However, according to at least one example embodiment, the main circuit board 20 may be arranged inside the housing 10 externally of the board rack 30, e.g. being arranged above or below the board rack 30. The board rack 30 will be further elucidated with reference to Fig .3.

As illustrated in Fig. 1, the board rack 30 and the circuit boards attached thereto (in Fig. 1, only the main circuit board 20) may easily be accessed by removing the actuator hatch 14. The actuator hatch 14 is preferably arranged, dimensioned and configured to, in an open position, allow access to the board rack 30, and thereby enable access to any circuit board in the board rack 30 and for the possibility to add a circuit board to, and/or remove a circuit board from, the board rack 30. The actuator hatch 14 may be considered as being a part of the housing 10, and may be connected to the remaining part of the housing 10 by any conventional means, such as e.g. by hinges. Preferably, the actuator hatch 14 is, in a closed position, configured to be in a sealing connection to the remaining part of the housing 10 in order hinder liquid or particles to enter inside of the housing 10.

The procedure of how the electric actuator 1 can control a motor operated valve will now be briefly discussed with reference to Fig .1.

The electric actuator 1 in Fig. 1 further comprises an actuator spindle 3 arranged at least partly inside the housing 10, a gear arrangement 5 arranged inside the housing 10, and an electric motor 7 operatively connected to the actuator spindle 3 via the gear arrangement 5.

The actuator spindle 3 is configured to control the movement of a valve rod (not shown) of a valve (i.e. a motor operated valve), in order to vary an opening of the valve. Furthermore, the main circuit board 20 is configured to transmit a motor control signal for controlling the electric motor 7, and thus controlling the motor operated valve (shown in Fig. 4).

According to at least one example embodiment, the electric actuator 1 may function as described in the following paragraph. The main circuit board 20 receives a first signal (the first signal may e.g. be a signal from a temperature sensor or a pressure sensor received by a measuring/logging board in the electric actuator 1, the measuring/logging board may e.g. be one of the secondary boards described with reference to Fig. 2), or alternatively the main circuit board includes a processing unit and/or an internally memory comprising information of how the electric actuator 1 are to control the electric motor 7, for example in an automatic calibration mode or an auto-recognition of end positions of the actuator spindle 3 and/or the valve rod. Subsequently the main circuit board 1 may process the first signal (possibly by communication with a secondary circuit board attached to the board rack 30, described with reference to Fig. 2) and transmit a control signal to the electric motor 7 of the electric actuator 1. Thus, the control signal may be used to initiate a rotational movement of the electric motor 7, which in turn transfers its rotational movement to the gear arrangement 5 (such as to an at least one gear wheel of the gear arrangement 5), which gear arrangement 5 transfer the rotational movement into a movement of the actuator spindle 7 (in Fig. 1, typically a reciprocal movement of the actuator spindle 7). The movement of the actuator spindle 7 is transferred to the valve rod in order to vary the opening of the motor operated valve.

It should be understood that the motor operated valve may comprise, or house, the electric motor instead of the electric actuator 1, such electric motor may be referred to as a valve integrated motor. For such embodiments, the valve integrated motor is preferably water-proof (e.g. by having a liquid-secured motor housing) and may additionally be directly connected to the valve rod. For such embodiments, the gear arrangement and the actuator spindle may be dispensed with, as the main circuit board 20 is configured to transmit a motor control signal to the valve integrated motor, which in turn is directly connected to, and configured to move, the valve rod. According to at least one example embodiment, a gear arrangement is also comprised in the motor operated valve, the gear arrangement preferably being arranged between the valve integrated motor and the valve rod.

Fig. 2 shows the same, or a similar, electric actuator 1' as shown in Fig. 1, why the same reference numerals for various features used in Fig. 1, are used in Fig. 2 as well. Such features are not described in detail again with reference to Fig. 2. However, in Fig. 2, adding a circuit board to and/or remove a circuit from the board rack 30 is visualized, hence the electric actuator 1' in Fig. 2 comprises in addition to the main circuit board 20, at least one secondary circuit board 40. The at least one secondary circuit board 40 is configured to transmit a signal to and/or receive a single from, the main circuit board 20.

As seen in Fig. 2, a first secondary board 40 is attached to the board rack 30, and is thus connected to the electric actuator 1'. A second secondary circuit board 42 is in the process of being connected to the board rack 30 manually, by the hand of an installer. The connection of the second secondary circuit board 42 may be carried out during manufacturing of the electric actuator 1' at the actuator manufacturing facility, or alternatively be connected to the electric actuator 1' after the electric actuator 1' has left the actuator manufacturing facility, possibly after the electric actuator 1' has be connected to a corresponding valve during e.g. an upgrade of the electric actuator 1'.

Thus, an installer may carry out the step of inserting at least one secondary circuit board 40, 42 (such as the second secondary board 42), into the board rack 30, and/or the step of removing the main circuit board 20 and/or at least one secondary circuit board 40, 42 from the board rack 30. For embodiments comprising the actuator hatch 14 (as the electric actuator 1 of Fig .1), the installer may carry out the step of opening the actuator hatch 14 in order to enable access to the circuit boards 20, 40, 42 in the board rack 30. The step is naturally performed prior to the step of inserting at least one secondary circuit board 40, 42 and/or removing the main circuit board 20 and/or at least one secondary circuit board 40, 42. When the installer is finished with altering (or replacing) the circuit boards 20, 40, 42, the actuator hatch is typically closed again.

Hereby functions associated with the inserted and/or removed circuit board, 30, 40, 42 may be added and/or removed from the electric actuator 1', respectively.

Any one of the secondary circuit boards 40, 42, or any other secondary circuit boards connected to the board rack 30 prior or after manufacturing of the electric actuator 1' may be any one of the following: a communication board, a high voltage board, a relay board, a digital output port, a radio board, a measuring/logging board. According to at least one example embodiment, any one of the circuit boards 20, 40, 42 may include more than one function. Thus, a circuit board may be configured to carry out a plurality of functions.

The board rack 30 of Fig. 1 and Fig 2 will now be described in more detail with reference to Fig. 3 showing an enlarged view of the board rack 30, and the circuit boards attached thereto, such as the main circuit board 20, a first secondary circuit board 40, a second secondary circuit board 42, and a third secondary circuit board 44.

The board rack 30 comprises a plurality of guiding structures 32 (of which only some are indicated in Fig. 3), each guiding structure 32 enabling one of the plurality of circuit boards 20, 40 ,42, 44 to be guided into and/or removed from the board rack 30. Each one of the guiding structure in Fig. 3, comprises a set of guiding rails 34 (of which only some are indicated in Fig. 3) for slidably arranging one of the plurality of circuit boards 20, 40, 42, 44 in the board rack 30.

The board rack 30 comprises a plurality of circuit board slots 31, each one of the plurality of circuit board slots 31 being associated with one of the plurality of circuit boards 20, 40, 42, 44. That is, each one of the plurality circuit board slots 31 is configured to receive a respective circuit board 20, 40, 42, 44, such as e.g. the main circuit board 20 or any one of the secondary circuit boards 40, 42, 44. Each one of the plurality of circuit board slots 31 comprises at least one securing element 70 for securing the respective circuit board 20, 40, 42, 44 inserted into the respective circuit board slot 31 in the board rack.

As illustrated in Fig. 3, the securing elements are represented by screws for firmly securing the respective circuit board 20, 40, 42, 44 to the board rack 30.

In Fig. 3, at least two of the securing elements 70 are arranged in a stepped manner. That is, two securing elements 70 related to two different circuit board slots 31 arranged on different levels (i.e. different circuit board levels) in the board rack 30. Thus, an installer may access the securing elements 70 for each circuit board 20, 40, 42, 44, at any time, as the stepped arrangement of the securing elements 70 implies that any circuit board attached in a relatively higher level in the board rack will not obstruct access to the securing element 70 of a circuit board attached in a relatively lower level in a the board rack 30.

As seen in Fig. 3, the board rack 30 itself is arranged in stepped manner. That is, a first circuit board slot arranged in a first circuit board level is arranged in a stepped manner to a second circuit board slot arranged in a second circuit board level, the second circuit board level being different from the first circuit board level. In other words, portions of the circuit boards at different vertical levels constitute parts of treads in reference to stair steps.

As can be seen in both Fig. 2 and Fig. 3, the electric actuator 1' comprises a back plate 50 perpendicularly arranged compared to at least the main circuit board 20 (but in Fig. 2 and 3 the back plate is perpendicularly arranged to any circuit board 20, 40, 42, 44 attached to the board rack) The back plate 50 comprises at least a first connector 60 connecting the back plate 50 to the main circuit board 20. Furthermore, in Fig. 3, a second connector 62 connects the second secondary circuit board 42 to the back plate 50, and a third connector 64 connects the third secondary circuit board 44 to the back plate 50. Preferably, the back plate 50 comprises a connector for each circuit board slot being arranged to hold a circuit board.

The back plate 50 further comprises a communication circuitry 51 enabling signal transfer between the main circuit board 20 and at least one of the secondary circuit boards 40, 42, 44. As shown in Fig. 3, the communication circuitry also enables communication between at least two secondary circuit boards, such as between the second and third secondary circuit boards 42, 44.

Note that in Fig. 3, the back plate 50 is arranged in two back plate portions, a first back plate portion 52 comprising the first and the third connectors 60, 64, and a second back plate portion 54 comprising the second connector 62. However, according to at least one example embodiment, the back plate 50 is made in one piece.

According to at least one alternative example embodiment, the electric actuator 1,1' comprises a set of separate wires (not shown) for internally connecting the main circuit board 20 to at least one of the plurality of circuit boards 40, 42, 44. Hence, in such embodiments, the back plate 50 may be dispensed with.

Fig. 4 illustrates an actuator-valve 100 assembly installed in a fluid distribution system 300, the actuator-valve assembly comprising an electric actuator 101 and a motor operated valve 201. The electric actuator 101 may be the same, or be similar to, any of the electric actuators 1,1' of Fig. 1 and Fig. 2, respectively. As an alternative, the electric actuator 101 is a more basic actuator not comprising an electric motor, and the electric motor is instead integrated into the motor operated valve 201 as previously described. For such embodiments, the electric actuator 101 need not to comprise any gear arrangement or an actuator spindle, but may be connected to the motor operated valve (such as to a valve integrated motor) simply by electric means, such as wires or any other connection circuitry.

It should be understood that the present inventive concept is not limited to the described exemplary embodiments; rather the scope being generally defined by the accompanying claims. For example the valve board rack 30 need not to be formed in a stepped manner, but only the securing elements 70 may be arranged in a stepped manner, according to at least one example embodiment. Moreover, more secondary circuit boards than those described here can be included in the actuator 1,1', either during manufacturing of the actuator 1, 1' or after the actuator 1, 1' has left the actuator manufacturing facility. As already noted, the actuator 1,1' need not to comprise the electric motor, but the motor operated valve may comprise the electric motor. Furthermore, the securing elements 70 may be configured differently, for example they need not to be arranged in a step manner if the securing elements can be accessed from the front of the board rack 30. That is, if the securing element is easily accessed in a plane being perpendicular to at least to the main circuit board 20, and/or being parallel to the pack plate 50, but arranged on the opposite side of the circuit boards compared to the back plate 50, the securing elements can be arranged in different levels in the same plane.

## Claims

1. An electric actuator for controlling a motor operated valve, comprising:
a housing,
a main circuit board arranged inside said housing, said main circuit board being configured to transmit a motor control signal for controlling the motor operated valve,
a board rack arranged inside said housing, said board rack being configured to receive a plurality of circuit boards,
wherein said board rack comprises a plurality of guiding structures, each guiding structure enabling one of the plurality of circuit boards to be guided into and/or removed from said board rack.

2. The electric actuator according to claim 1, wherein each one of said guiding structures comprises a set of guiding rails for slidably arranging one of the plurality of circuit boards in said board rack.

3. The electric actuator according to any one of the preceding claims, further comprising at least one secondary circuit board configured to transmit a signal to and/or receive a signal from said main circuit board.

4. The electric actuator according to claim 3, wherein the at least one secondary circuit board is one of the following: a communication board, a high voltage board, a relay board, a digital output port, a radio board, a measuring/logging board.

5. The electric actuator according to any one of the preceding claims, wherein said main circuit board is arranged in said board rack.

6. The electric actuator according to any one of the preceding claims, further comprising a back plate comprising a connector connecting said back plate to said main circuit board.

7. The electric actuator according to claim 6, wherein said back plate comprises a communication circuitry enabling signal transfer between the main circuit board and at least one of the plurality of circuit boards.

8. The electric actuator according to any one of claims 6-7, wherein said back plate is perpendicularly arranged compared to the main circuit board.

9. The electric actuator according to any one of the preceding claims, wherein said board rack comprises a plurality circuit board slots, each one of the plurality of circuit board slots being associated with one of the plurality of circuit boards, and each one of the plurality of circuit board slots comprising at least one securing element for securing the respective circuit board of the plurality of circuit boards to the board rack.

10. The electric actuator according to claim 9, wherein at least two of the securing elements is arranged in a stepped manner.

11. The electric actuator according to any one of the preceding claims, wherein said housing comprises an actuator hatch being arrangeable in at least a closed position and an open position, and wherein said actuator hatch in said open position enables access to the board rack.

12. The electric actuator according to any one of the preceding claims, comprising at least two secondary circuit boards, wherein any one, or both, of the two secondary circuit boards are chosen from the following circuit board types: communication board, high voltage board, relay board, digital output port, a radio board, measuring/logging board.

13. The electric actuator according to any one of the preceding claims, further comprising:
an actuator spindle arranged at least partly inside said housing, said actuator spindle being configured to control the movement of a valve rod in order to vary an opening of the valve;
a gear arrangement;
an electric motor operatively connected to the actuator spindle via said gear arrangement.

14. Method for inserting and/or removing a circuit board in an electric actuator according to any one of claims 1-13, said method comprising the steps of:
inserting at least one secondary circuit board into the board rack, and/or
removing the main circuit board and/or at least one secondary circuit board from the board rack.

15. Method according to claim 14 for the electric actuator of claim 11, comprising the step of opening the actuator hatch in order to enable access to the circuit boards in the board rack prior to the step of inserting at least one secondary circuit board and/or removing the main circuit board and/or at least one secondary circuit board.
